Europäisches Patentamt

European Patent Office

Office européen des brevets

(19)

(11) EP 0 642 181 B1

(12) FASCICULE DE BREVET EUROPEEN

(45) Date de publication et mention
de la délivrance du brevet:
**09.06.1999 Bulletin 1999/23**

(51) Int Cl.⁶: **H01L 43/08**, G11B 5/39

(21) Numéro de dépôt: **94401931.4**

(22) Date de dépôt: **31.08.1994**

(54) **Composant et capteur magnétorésistifs à motif géométrique répété**

Magnetoresistive Anordnung und Fühler mit wiederholenden geometrischen Strukturen

Magnetoresistive device and sensor with a geometric repetitive pattern

(84) Etats contractants désignés:
**DE FR GB IT**

(30) Priorité: **02.09.1993 FR 9310458**

(43) Date de publication de la demande:
**08.03.1995 Bulletin 1995/10**

(73) Titulaire: **COMMISSARIAT A L'ENERGIE
ATOMIQUE
75015 Paris (FR)**

(72) Inventeurs:
 • **Mouchot, Jean
   F-38000 Grenoble (FR)**
 • **Fedeli, Jean-Marc
   F-38140 Beaucroissant (FR)**
 • **Vieux-Rochaz, Line
   F-38360 Sassenage (FR)**
 • **Vaudaine, Marie-Hélène
   F-38180 Seyssins (FR)**

(74) Mandataire: **Dubois-Chabert, Guy et al
   c/o BREVATOME
   25, rue de Ponthieu
   75008 Paris (FR)**

(56) Documents cités:
   **EP-A- 0 366 396          EP-A- 0 534 791
   EP-A- 0 548 841**

 • **PATENT ABSTRACTS OF JAPAN vol. 7 no. 36
   (E-158) ,15 Février 1983 & JP-A-57 190381
   (NIPPON ELECTRIC CO) 22 Novembre 1982**
 • **PATENT ABSTRACTS OF JAPAN vol. 13 no. 201
   (E-757) ,12 Mai 1989 & JP-A-01 022076 (FUJITSU
   LTD) 25 Janvier 1989**

## Description

La présente invention a pour objet un composant magnétorésistif à motif géométrique répété et un capteur à effet magnétorésistif utilisant ce composant. Ce capteur est plus particulièrement destiné à la réalisation de têtes de lecture et/ou d'écriture d'informations enregistrées sous forme magnétique sur un support quelconque tel que disque dur, bande, disquette, ticket, carte, etc.

Ce capteur peut aussi servir pour la détection et la localisation de champs magnétiques faibles tels que le champ magnétique terrestre et la fuite de faibles champs magnétiques, associée à la présence de fissures dans des systèmes métalliques.

Les composants magnétorésistifs se présentent généralement sous la forme d'un barreau magnétorésistif de petite taille, dont les extrémités sont reliées à des amenées de courant destinées à faire circuler un courant dans le barreau. En présence d'un champ magnétique extérieur, l'aimantation M du barreau résistif s'oriente différemment ayant pour effet de modifier la résistivité du matériau. Une variation de la tension est alors observée aux bornes du barreau et la mesure de cette variation de tension est représentative de la valeur du champ magnétique extérieur. Elle peut aussi être représentative de sa direction.

Ainsi, en mesurant la résistance du barreau on peut mesurer un champ magnétique et réciproquement mesurer une résistance électrique en mesurant un champ magnétique.

Les capteurs magnétiques les plus récents utilisent des matériaux magnétorésistifs, déposés sous forme de film mince sur un substrat adapté. Ces films sont gravés selon les procédés de photolithographie afin de leur conférer la forme d'un barreau.

On définit le champ magnétique à saturation $H_s$ comme étant le champ magnétique appliqué au composant magnétorésistif au-dessus duquel la résistivité électrique intrinsèque $\rho$ du composant ne varie pratiquement plus.

On définit le rapport :

$$\frac{\Delta\rho}{\rho} = \frac{\left[\rho(H=0) - \rho(H=Hs)\right]}{\rho(H=0)}$$

où H représente la valeur du champ appliqué : $\rho(H=0)$ est la résistivité du composant magnétorésistif en champ nul et $\rho(H=Hs)$ sa résistivité lorsque le composant est en présence d'un champ magnétique égal au champ à saturation.

En outre, $\Delta\rho/\rho=\Delta R/R$, avec R représentant la résistance du composant magnétorésistif.

La sensibilité $\alpha$ de la structure magnétorésis-tive et donc celle d'un capteur à effet magnétorésistif sont définies par la variation de la magnétorésistance $\Delta R/R$, obtenue par application d'un champ magnétique unitaire ; elle satisfait à la relation :

$$\alpha=(\partial(\Delta R/R)/\partial H)_{H<Hs}.$$

La forme d'un composant magnétorésistif ou plutôt ses dimensions influent sur l'orientation de son aimantation. Ainsi, dans le cas d'une couche mince magnétique, l'aimantation a tendance à s'aligner dans le plan de la couche. De plus, dans le cas d'un barreau de grande longueur, l'aimantation est généralement orientée selon cette longueur. Cet effet traduit une recherche du minimum d'énergie magnétique.

Pour une direction d'aimantation donnée, il apparaît, dans le matériau, un champ magnétique appelé champ démagnétisant $H_d$ ou champ d'anisotropie de forme orienté dans la direction contraire à celle de l'aimantation. L'intensité du champ démagnétisant est fonction de la géométrie du matériau considéré et de la direction prise par l'aimantation en son sein.

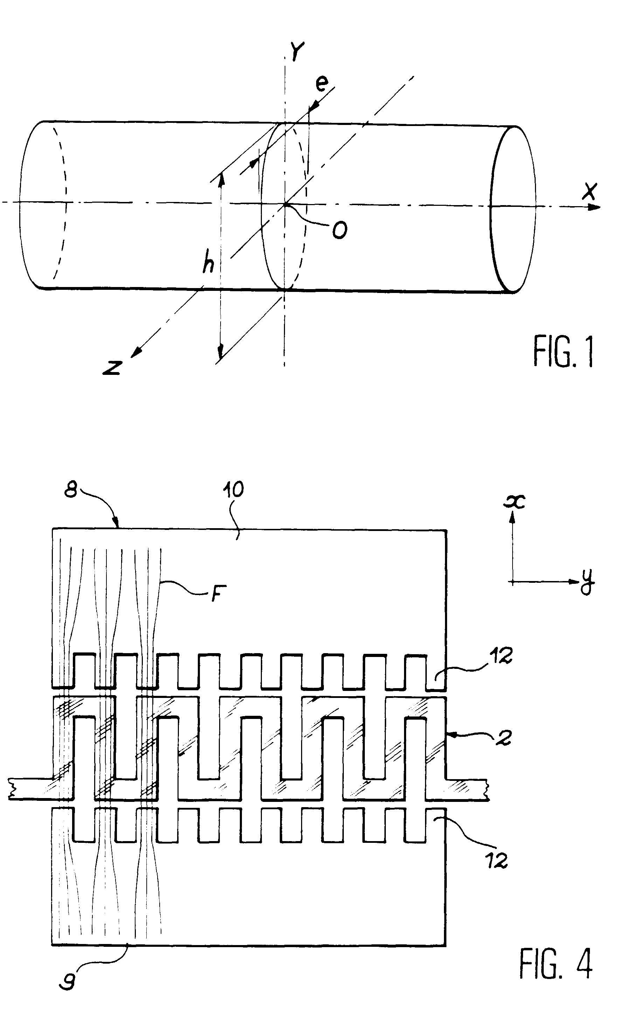

Sur la figure 1, on a représenté schématiquement un barreau magnétique de section elliptique, afin d'illustrer les composantes de ce champ démagnétisant.

On note les valeurs des coefficients de champ démagnétisant $N_X$, $N_Y$ et $N_Z$ respectivement selon les directions X, Y et Z d'un repère orthonormé OXYZ. Lorsque l'aimantation M est parallèle à la direction X, le champ démagnétisant vérifie la relation $H_d=N_X.M$.

Pour un barreau magnétorésistif de section elliptique supposé infiniment long aligné selon la direction X et présentant une épaisseur $\underline{e}$ selon la direction Z et une hauteur h selon la direction Y, on vérifie les relations : $N_X=0$, $N_Y=e/(h+e)$, $N_Z=h/(h+e)$.

Dans le cas d'un barreau de section rectangulaire d'épaisseur e faible devant sa hauteur h, elle même faible devant sa longueur L, une première approximation consiste à considérer que : $N_X=0$, $N_Y=e/h$, $N_Z=1$.

Ainsi, un champ magnétique extérieur H appliqué selon la direction Y sera diminué, au sein du composant magnétorésistif par le champ démagnétisant $H_d$ approximativement égal dans le dernier cas particulier à (e/h).M, alors que ce même champ appliqué selon la direction X ne sera pas diminué.

Notons que cette approche n'est plus rigoureuse dès que la longueur du composant est comparable à sa hauteur (ou largeur).

Ainsi, le champ démagnétisant est susceptible d'augmenter la valeur du champ à saturation Hs et donc de diminuer la sensibilité du capteur.

Jusqu'à présent, les matériaux magnétorésistifs qui servaient à la réalisation des capteurs magnétiques étaient des matériaux monolithiques du type ferromagnétique. Il s'agissait principalement des composés à base de fer et de nickel ($Fe_{19}Ni_{81}$, $Fe_{20}Ni_{80}$) et

des composés à base de fer, de nickel et de cobalt ($Fe_{15}Ni_{65}Co_{20}$, $Fe_5Ni_{80}Co_{15}$, ...).

Actuellement, de nouveaux matériaux magnétorésistifs sont disponibles. Il s'agit de structures magnétiques multicouches métalliques (SMMM) constituées d'un empilement de couches magnétiques séparées par des couches métalliques non magnétiques d'une épaisseur telle que s'établisse un couplage antiferromagnétique entre les couches magnétiques.

Les structures magnétiques multicouches métalliques étudiées sont variées. Elles sont constituées de métaux choisis parmi le cobalt, le fer, le nickel, les alliages de fer et de nickel, le cuivre, le chrome, l'argent, l'or, le molybdène, le ruthénium et le manganèse, comme décrit dans le document (1) de H. Yamamoto et T. Shinjo (IEEE Translation Journal on Magnetics in Japan, vol.7, n°9. Septembre 1992, "Magnetoresistance of multilayers", p. 674-684).

Les SMMM présentant à ce jour le plus grand nombre de propriétés requises (large effet magnétorésistif, faible champ à saturation, faible coercitivité, bonne tenue au recuit) sont constituées de couches de FeNi séparées par des couches de cuivre comme décrit dans le document (2) de S.S.P. Parkin ("Oscillations in giant magnetoresistance and antiferromagnetic coupling in $[Ni_{81}Fe_{19}/Cu]_N$ N multilayers", Appl. Phys. Lett. 60, n°4, Janvier 1992, p. 512-514) et le document (3) de R. Nakatani et al. (IEEE Transactions on Magnetics, vol.28, n°5, Septembre 1992, "Giant magnetoresistance in Ni-Fe/Cu multilayers formed by ion beam sputtering", p. 2668-2670) ou encore de couches minces de FeNi séparées par des couches d'argent, comme décrit dans le document (4) de B. Rodmacq et al., (Journal of Magnetism and Magnetic materials 118, 1993, p.L11-L16, "Magnetoresistive properties and thermal stability of Ni-Fe/Ag multilayers").

Ces nouveaux matériaux ont la propriété d'être fortement magnétorésistifs, c'est-à-dire d'avoir un rapport $\Delta\rho/\rho$ allant de 10 à 20%, et de présenter des champs magnétiques à saturation faibles, c'est-à-dire inférieurs à 40kA/m.

Dans les SMMM l'effet magnétorésistif correspond à la rotation des aimantations de chacune des couches magnétiques qui s'accompagnent d'une diminution de la résistance électrique lors de l'application d'un champ magnétique extérieur. Le champ à saturation Hs correspond dans ce cas au champ magnétique qu'il faut appliquer pour orienter, dans une même direction et un même sens, l'aimantation de chacune des différentes couches magnétiques.

Dans le cas des matériaux ferromagnétiques utilisés dans les magnétorésistances monolithiques, la résistance varie avec l'angle que forme la direction de la densité de courant qui traverse le composant et la direction d'aimantation dans ce matériau. La résistance est la plus faible lorsque cet angle est égal à $\frac{\pi}{2}$. On n'a donc pas intérêt dans ce cas à appliquer le champ magnétique dans n'importe quelle direction, mais perpendiculairement à la longueur du composant magnétorésistif.

En revanche, parallèlement à la longueur du barreau, il n'y a pas d'effet magnétorésistif au sein des matériaux ferromagnétiques monolithiques.

Dans les nouvelles structures SMMM, la variation de la résistivité, et donc de la résistance, est indépendante de l'angle formé entre la direction du champ présent au sein du composant magnétorésistif et de la direction du courant qui le traverse.

Mais ce champ est égal à la différence entre le champ démagnétisant $H_d$ et le champ magnétique H extérieur appliqué. Compte tenu que la forme et la dimension de ces structures SMMM sont telles que, d'un point de vue magnétique, ces structures SMMM sont généralement anisotropes, le champ démagnétisant n'est pas identique dans toutes les directions de l'espace. Ainsi, la sensibilité des composants varie avec la direction du champ magnétique à mesurer, dès lors que ceux-ci présentent une anisotropie de forme.

L'invention a justement pour objet un composant magnétorésistif et un capteur utilisant ce composant applicable éventuellement aux matériaux ferromagnétiques monolithiques et particulièrement aux structures magnétiques multicouches métalliques, présentant par rapport aux composants et capteurs de l'art antérieur une réduction des effets de champ démagnétisant et donc une augmentation de la sensibilité.

Selon l'invention, le composant magnétorésistif tel que revendiqué dans la revendication 1 comporte une bande magnétorésistive de type multicouche repliée selon un motif géométrique répété, de manière à présenter au moins une série de tronçons sensiblement parallèles permettant de réduire les champs démagnétisants, la bande magnétorésistive étant formée d'un empilement de couches en matériau métallique magnétique, séparées par des couches en matériau métallique non magnétique.

La bande agencée selon l'invention confère donc au composant à la fois une grande sensibilité lorsque le champ à mesurer lui est appliqué dans la direction des tronçons et par conséquent aussi une grande directivité. En fait, chaque tronçon peut être assimilé à un barreau magnétorésistif "infiniment long".

Effectivement, lorsqu'un champ magnétique à mesurer est appliqué au composant sensiblement dans la direction des tronçons de la bande magnétorésistive, le champ démagnétisant apparaissant dans le matériau est particulièrement faible. Il en résulte que le champ à saturation équivaut à celui du matériau "massif", c'est-à-dire ne présentant pas d'anisotropie liée à la forme du matériau magnétique.

Le composant est donc très sensible aux champs parallèles aux tronçons. A l'inverse, lorsque le champ est appliqué perpendiculairement à la direction des tronçons, l'effet du champ démagnétisant intervient fortement, ce qui augmente le champ à saturation et par conséquent réduit la sensibilité du composant.

Avantageusement, le motif peut être de type serpentin, en dents de scie, en forme de grecque ou crénelé. Un motif en créneau apparaît comme une solution particulièrement intéressante. En effet, la bande magnétorésistive présente dans ce cas une première série de tronçons alignés selon une première direction et une seconde série de tronçons perpendiculaires à ceux de la première série. La longueur des tronçons de chaque série, ainsi que leur largeur seront ajustés de manière à conférer au composant les caractéristiques requises pour son application.

En fonction de l'application envisagée du composant et en particulier dans des capteurs pour lecture d'informations sur des supports magnétiques ou dans des capteurs directifs du type boussole, on privilégiera la sensibilité, et/ou la directivité du composant.

La directivité, de même que la sensibilité du composant sont fonction du motif des tronçons.

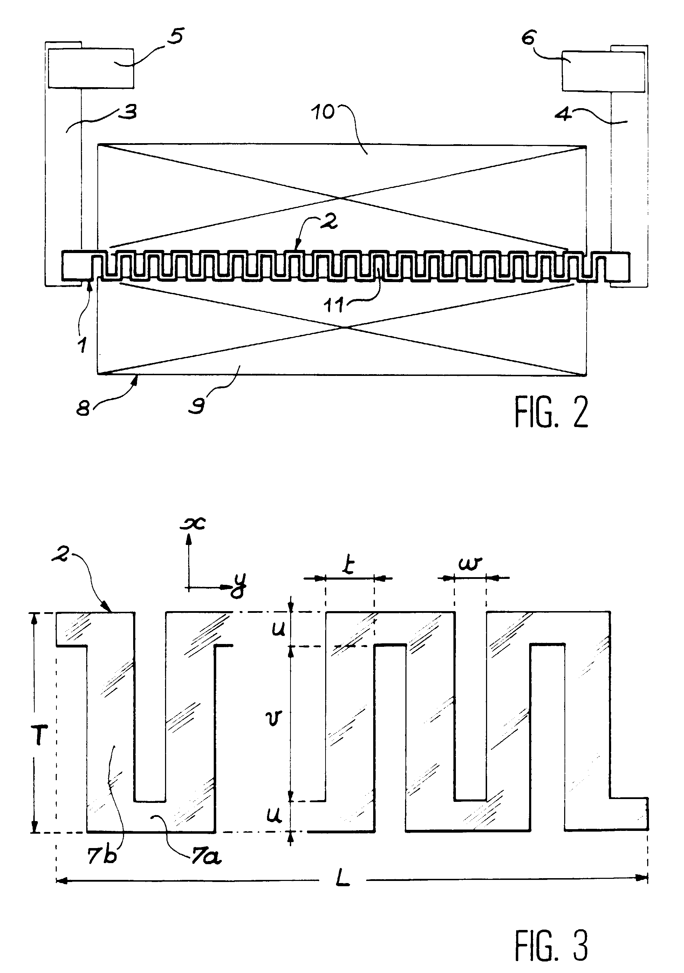

Dans le motif en créneau, on peut introduire une grande disproportion entre les tronçons "parallèles" et "perpendiculaires" et considérer qu'il n'y a qu'une série de tronçons. Cette série est la série des tronçons les plus longs qui, dans le cas des figures 2, 3 et 4 sont orientés perpendiculairement au sens de la longueur du composant et qui sont les plus sensibles. Par ailleurs, la longueur des tronçons est choisie très supérieure à leur largeur. Cet agencement est plus spécialement adapté à la réalisation d'un capteur directif.

Dans un motif en dents de scie on distingue deux séries de tronçons correspondant respectivement aux rampes de part et d'autre de chaque dent.

Les motifs de la bande magnétorésistive sont de préférence définis par un procédé de photolithogravure qui permet de jouer sur les différents paramètres géométriques avec une grande précision et d'optimiser la taille et la forme des tronçons.

La bande magnétorésistive est réalisée en des matériaux du type multicouches constitués d'un empilement de couches en matériau métallique magnétique et de couches en matériau métallique non magnétique.

De préférence, on utilise comme matériau magnétique un alliage de fer, de nickel et de cobalt (FeNiCo) ou un alliage de fer et de nickel (FeNi). En outre, le matériau non magnétique des structures multicouches est avantageusement du cuivre ou de l'argent.

L'invention a aussi pour objet un capteur à effet magnétorésistif utilisant le composant magnétorésistif décrit précédemment, supporté par un substrat non conducteur, et comprenant des amenées de courant connectées aux deux extrémités du composant magnétorésistif (tel que revendiqué dans la revendication 7).

Par substrat non conducteur, il faut comprendre un substrat semi-conducteur ou isolant. Ce substrat peut être en silicium mono- ou polycristallin, en arséniure de gallium, en verre, en matière organique telle qu'un polyimide (sous la marque déposée Kapton) ou même en un métal recouvert d'un isolant électrique.

Lorsque le substrat est semi-conducteur, un isolant électrique peut éventuellement être prévu entre le composant magnétorésistif et le substrat.

Avantageusement, le capteur est recouvert d'un film de protection en matériau isolant électrique comportant des ouvertures en regard des extrémités de la bande, afin d'assurer le passage des amenées de courant.

Dans certains cas, il peut être préférable d'associer un guide de flux magnétique au composant magnétorésistif. Le rôle de ce guide est de capter les lignes de champs magnétiques pour les concentrer et les orienter selon les tronçons les plus sensibles de la bande magnétorésistive.

L'utilisation ou non de ce guide dépend de l'intensité des champs magnétiques à lire et de la sensibilité des matériaux constituant le composant magnétorésistif.

De plus, la forme du guide de flux est fonction de la forme de la bande magnétorésistive.

Dans tous les cas la forme du guide doit être telle qu'elle concentre les lignes de champ magnétique au sein des tronçons les plus sensibles.

En particulier, le guide peut comporter des languettes adaptées à guider les lignes de champ. La forme, l'espacement et selon le cas la périodicité des languettes sont adaptés pour convenir à la forme de la bande magnétorésistive et à la disposition des tronçons les plus sensibles de cette bande.

L'emploi d'un guide de flux associé à un composant magnétorésistif monolithique est décrit notamment dans les documents (5) EP-A-445 883 et (6) EP-A-423 878.

Le capteur de l'invention est en particulier destiné à l'équipement d'une tête magnétique de lecture et/ou d'écriture d'informations magnétiques sur une piste magnétique, du type bande magnétique, disque dur, etc. Dans ce cas, le composant magnétorésistif doit présenter une longueur totale égale ou inférieure à la largeur de la piste magnétique.

L'enregistrement des informations peut être fait soit parallèlement, soit perpendiculairement au sens de défilement de la piste.

D'autres caractéristiques et avantages de l'invention ressortiront mieux de la description qui va suivre, donnée à titre illustratif et non limitatif.

La description se réfère aux figures annexées, dans lesquels :

- la figure 1, déjà décrite, représente schématiquement un barreau magnétorésistif de section elliptique permettant l'illustration des champs démagnétisants ;
- la figure 2 représente schématiquement, en vue de dessus, un capteur magnétorésistif conforme à l'invention muni d'un guide de flux ;
- la figure 3 représente schématiquement et à échelle agrandie, un détail de la bande magnétorésistive ;
- la figure 4 représente schématiquement et à grande échelle un détail de réalisation du guide de flux et de la bande magnétorésistive et illustre la concentration de lignes de flux vers des tronçons perpendiculaires d'une bande magnétorésistive ;

- la figure 5 est une vue schématique en coupe d'un détail d'une bande magnétorésistive multicouche déposée sur un substrat ;

- les figures 6A à 6F représentent schématiquement, en coupe longitudinale, les différentes étapes de fabrication d'un composant magnétorésistif, conforme à l'invention ;

- les figures 7 et 8 représentent des variantes de forme possibles pour la bande magnétorésistive et pour le guide de flux ; et

- les figures 9 et 10 correspondent respectivement aux figures 7 et 8 et montrent une variante de disposition du guide de flux.

Comme illustré à la figure 2, le capteur comporte un composant magnétorésistif 1 multicouche présentant une bande magnétorésistive 2 repliée selon un motif en créneau rappelant la forme de certaines frettes grecques.

Les extrémités de la bande 2 sont reliées par des moyens d'amenées de courant 3, 4 à des prises de contact électrique 5,6.

Sur la figure 3 qui est une vue détaillée de la figure 2, les tronçons de la bande 2 parallèles à une direction y selon la longueur L du composant portent la référence 7a et les tronçons principaux 7, parallèles à la direction x perpendiculaire à y portent la référence 7b.

En outre, les paramètres u, v, w, t et T désignent respectivement la largeur des tronçons 7a, la longueur des tronçons principaux 7b, l'écart entre deux tronçons 7b consécutifs, la largeur des tronçons 7b et finalement la largeur du composant.

En ajustant ces paramètres, il est possible de modifier les caractéristiques du composant.

Dans le cas de l'application du capteur à une tête magnétique de lecture, un composant magnétorésistif de l'invention présentant une bande 2 repliée selon un créneau de paramètres $u=2\mu m$, $v=10\mu m$, $t=2\mu m$, $w=5\mu m$, $T=14\mu m$, $L=250\mu m$ convient parfaitement pour le remplacement d'un barreau magnétorésistif classique de $250\mu m$ de longueur et de $14\mu m$ de largeur.

Par contre, les champs à saturation sont fortement atténués par la forme particulière de la bande qui tend à réduire les champs démagnétisants induits dans le matériau magnétorésistif ; il s'en suit que la sensibilité $\alpha$ du capteur peut être bien supérieure à celle des composants des capteurs classiques.

En outre, la forme de la bande 2 entraîne une augmentation de la résistance électrique du composant 1 par rapport à un barreau droit. Cette augmentation de la résistance permet, à courant égal, une tension de lecture bien plus élevée.

Dans les cas où une très grande directivité du capteur est requise comme par exemple dans l'application à une boussole, la longueur v des tronçons 7b de la bande magnétorésistive 2 est choisie très supérieure à la largeur t.

Pour la bande en forme de grecque (ou crénelée), les tronçons principaux 7b, sont longs et fins. Dans la pratique, les paramètres sont tels que $0,2\mu m \leq t \leq 5\mu m$ et $v \geq 10\mu m$.

L'effet du champ démagnétisant est très important lorsque les lignes du champ magnétique à capter sont perpendiculaires aux tronçons principaux 7b de la bande 2 et négligeable lorsque ces lignes sont dirigées selon ces tronçons. Le champ à saturation revient alors à celui du matériau massif.

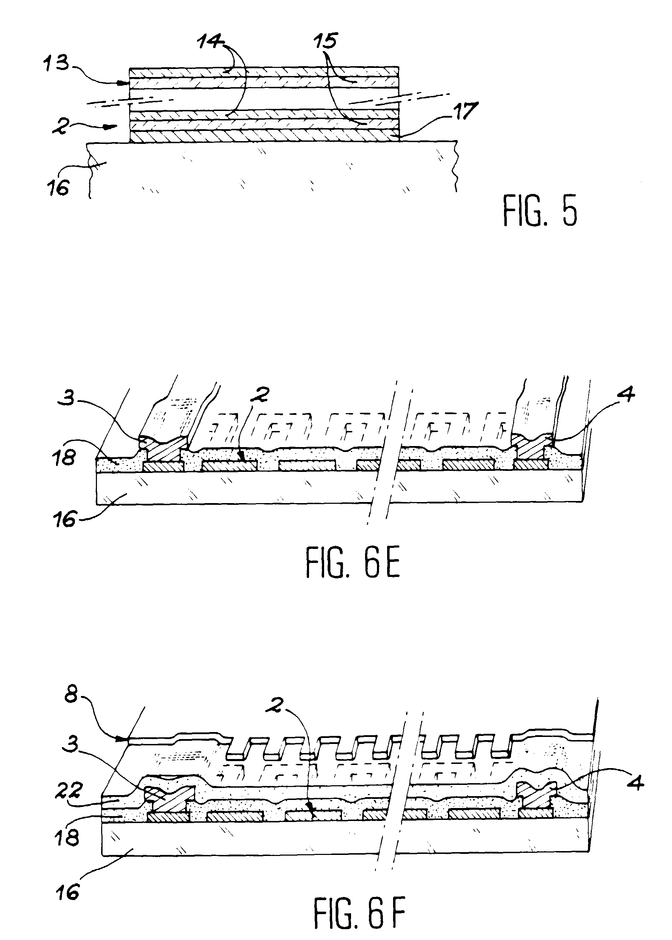

Pour augmenter encore la sensibilité et la directivité du capteur, le capteur peut comporter un guide de flux 8 présentant deux parties 9 et 10 séparées par un entrefer 11 et disposées de part et d'autre du composant magnétorésistif 1 (figure 2). Le guide de flux 8 permet de diriger préférentiellement les lignes F (figure 4) de champ magnétique à capter vers les tronçons principaux 7b de la bande magnétorésistive.

Dans un mode de réalisation préféré, illustré à la figure 4, le guide 8 comporte des languettes 12 à l'extrémité de chacune de ses parties 9 et 10 en regard de l'entrefer.

Les languettes 12 sont placées en regard et dans l'alignement des tronçons principaux 7b de la bande magnétorésistive 2 de manière à concentrer directement les lignes de champ F dans ces tronçons 7b.

Le capteur ainsi équipé est fortement directif et de grande résistivité électrique, ce qui autorise des mesures avec de faibles densités de courant pouvant être inférieures ou voisines du milliampère.

De préférence et comme représenté sur la figure 5, la bande magnétorésistive 2 est formée par un empilement 13 de couches magnétiques minces 14 séparées de couches non magnétiques métalliques minces 15. A titre d'exemple, ces couches magnétiques 14 sont en alliage de fer et nickel et les couches métalliques en cuivre ou argent. La bande comprendra par exemple 40 couches en alliage de fer et de nickel d'une épaisseur de 1.2 nm et 40 couches en argent de 1.1 nm d'épaisseur.

La bande 2 est déposée sur un substrat 16 semi-conducteur ou isolant qui peut être en verre, en silicium ou encore en Kapton.

Le dépôt préalable sur ce substrat 16 d'une fine couche métallique 17, de fer ou de cuivre par exemple, permet dans certaines SMMM d'améliorer la qualité cristalline de la structure multicouche et d'augmenter de ce fait les propriétés magnétorésistives.

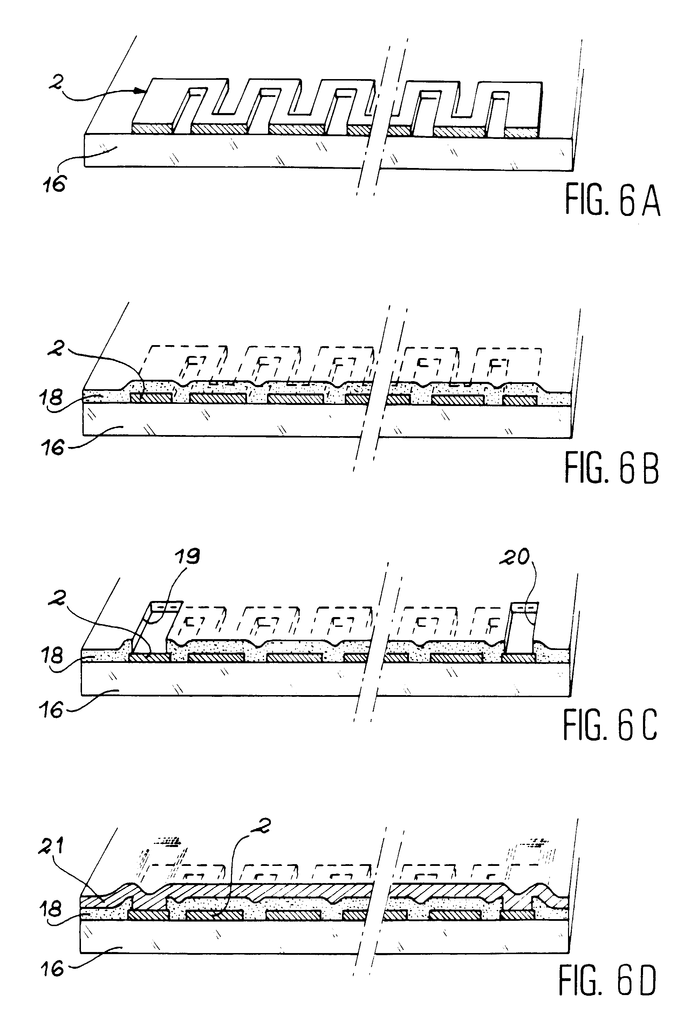

Comme l'illustre la figure 6A, la réalisation du composant magnétorésistif comprend donc tout d'abord le dépôt de la bande magnétorésistive 2 sur le substrat 16. Cette opération est réalisée par un dépôt d'un film magnétorésistif multicouche et éventuellement par le dépôt de la fine couche métallique 17 au préalable, qui sont ensuite gravés par usinage ionique. Pour ce faire, on a recours à un masque et à des procédés de photolithogravure.

Le dépôt des couches minces peut être réalisé par pulvérisation cathodique ou par évaporation sous vide ou encore par épitaxie de jets moléculaires en ce qui concerne la bande magnétorésistive multicouche.

Dans une seconde étape (figure 6B) un isolant électrique et magnétique 18 tel que la silice est déposé.

Puis, des ouvertures 19, 20 (comme représenté à la figure 6C) sont pratiquées dans l'isolant 18 de manière à prendre des contacts sur la bande magnétorésistive 2. Finalement, un matériau conducteur 21, par exemple en tungstène, est déposé (figure 6D) puis gravé (figure 6E) pour former les amenées de courant 3, 4.

La gravure est réalisée par voie chimique ou par usinage ionique.

Pour réaliser directement le capteur à effet magnétorésistif, on dépose une couche de silice 22 supplémentaire (figure 6F) pour l'isolation des amenées de courant 3, 4 et ensuite éventuellement un matériau magnétique doux en couche mince. Ce dernier est gravé afin de former le guide de flux 8. Sur la figure 6F, seule une partie du guide 8 de flux est représentée. Pour ce guide, des alliages de fer et de nickel ou de fer, d'aluminium et de silicium sont retenus.

En outre, des prises de contact, non représentées, sont réalisées sur les amenées de courant 3, 4 de manière à pouvoir connecter le capteur à un circuit électronique.

Sur la figures 6, le guide est réalisé après la bande magnétorésistive, cependant il pourrait être réalisé avant ladite bande (voir figure 2).

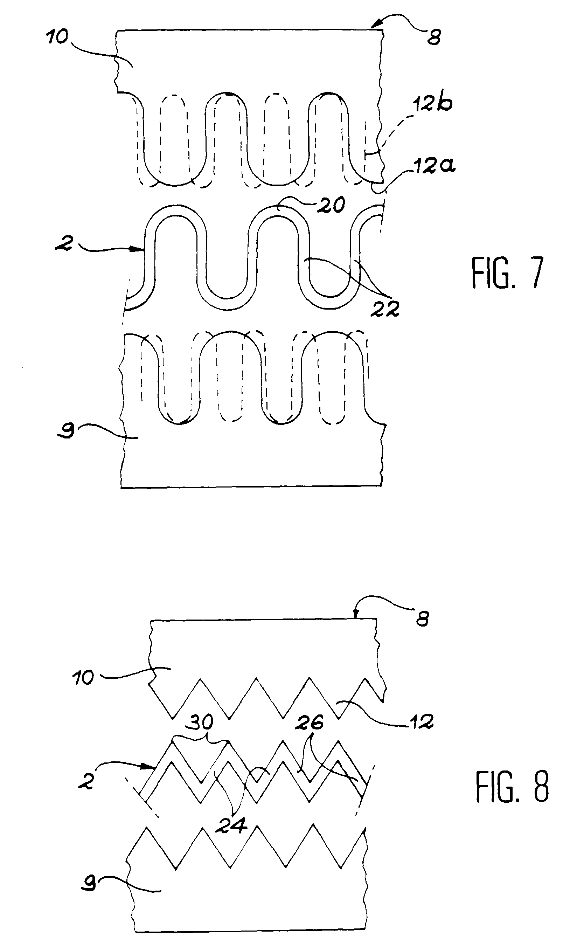

Les figures 7 et 8 représentent enfin des alternatives de forme pour la réalisation de la bande magnétorésistive et des guides de flux associés.

La figure 7 montre une bande magnétorésistive 2 de forme en serpentin, présentant, une succession de parties courbées 20 et de tronçons 22 perpendiculaires à la longueur du composant. Le guide de flux associé présente lui aussi une forme en serpentin. Celui-ci, peut comporter, par exemple, comme représenté en trait plein des languettes 12 dont la largeur correspond sensiblement à celle de chaque partie courbée 20 correspondante, de la bande 2. Ainsi, on a une languette 12 pour deux tronçons 22 consécutifs. Les languettes 12 peuvent aussi, comme représenté en trait interrompu, être plus fines et plus rapprochées en étant disposées en face de chaque tronçon 22 de la bande 2.

Dans un cas comme dans l'autre les languettes 12 dirigent les lignes de flux (non représentées) selon les tronçons 22 perpendiculaires à la longueur du composant qui sont les plus sensibles.

Le guide de flux représenté à la figure 8 comporte des languettes en dents de scie, destinées à diriger les lignes du champ à mesurer (non représentées) le long des tronçons 24 et 26 de la bande magnétorésistive 2 également repliée en dents de scie. En outre, comme représenté sur la figure les extrémités des languettes 12 sont disposées en face des pointes 30 formées à chaque intersection de deux tronçons 24 et 26 de la bande magnétorésistive.

Les languettes 12, 12a, 12b du guide de flux 8 peuvent être disposées en face et en retrait par rapport aux tronçons de la bande 2 comme cela apparaît sur les figures 7 et 8. Selon une variante de réalisation du capteur, les languettes 12, 12a peuvent également chevaucher en partie la bande magnétorésistive.

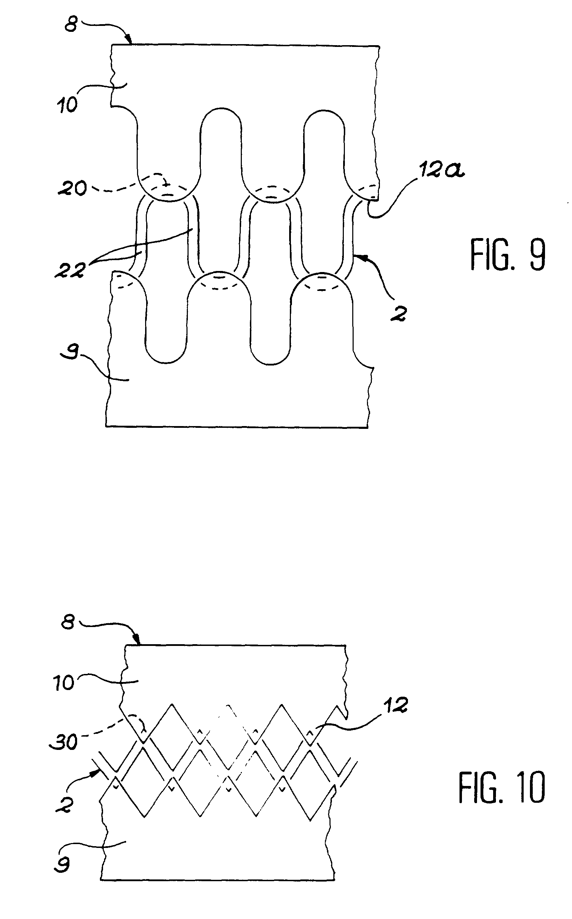

Comme le montrent les figures 9 et 10, qui, excepté le positionnement des parties 9 et 10 du guide de flux par rapport à la bande, sont identiques aux figures 7 et 8, les extrémités des languettes 12, 12a viennent chevaucher respectivement les pointes 30 et les parties courbées 20 de la bande 2.

## Revendications

1. Composant magnétorésistif comportant une bande magnétorésistive (2) de type multicouche repliée selon un motif géométrique répété (7a, 7b, 22, 24, 26), de manière à présenter au moins une série de tronçons (7a, 7b, 22, 24, 26) sensiblement parallèles à au moins une direction, la bande magnétorésistive (2) étant formée d'un empilement (13) de couches (14) indépendantes en matériau métallique magnétique, séparées par des couches (15) en matériau métallique non magnétique.

2. Composant magnétorésistif selon la revendication 1, caractérisé en ce que le motif est choisi parmi l'un des motifs suivants : motif serpentin (20, 22), motif en dents de scie (24, 26), motif crénelé (7a, 7b).

3. Composant magnétorésistif selon l'une quelconque des revendications 1 ou 2, caractérisé en ce la bande (2) est repliée selon un motif crénelé présentant deux séries (7a, 7b) de tronçons, respectivement alignés selon deux directions (x, y) sensiblement perpendiculaires entre elles.

4. Composant magnétorésistif selon l'une quelconque des revendications précédentes, caractérisé en ce que le matériau magnétique est un alliage de fer et de nickel.

5. Composant magnétorésistif selon l'une quelconque des revendications précédentes, caractérisé en ce que le matériau non magnétique est choisi parmi le cuivre et l'argent.

6. Composant magnétorésistif selon l'une quelconque des revendications précédentes, caractérisé en ce que le motif de la bande magnétorésistive (2) est susceptible d'être obtenu par un procédé de photolithographie.

**7.** Capteur à effet magnétorésistif destiné à la mesure de champs magnétiques, comportant un composant magnétorésistif (1), supporté par un substrat non conducteur (12), et des prises de contact (5, 6) reliées au composant (1) par des amenées de courant (3, 4), dans lequel le composant magnétorésistif (1) est conforme à l'une quelconque des revendications précédentes.

**8.** Capteur à effet magnétorésistif selon la revendication 7, caractérisé en ce que la largeur (t) des tronçons (7b) de l'une des séries est inférieure à la longueur (v) de ces tronçons.

**9.** Capteur à effet magnétorésistif selon la revendication 8, caractérisé en ce que ladite longueur v des tronçons (7b) est $\geq 10$ µm et la largeur t de ces tronçons telle que 0,2µm$\leq$t$\leq$5µm.

**10.** Capteur à effet magnétorésistif selon l'une quelconque des revendications 7 à 9, caractérisé en ce qu'il comporte en outre un guide (8) de flux pour orienter les lignes (F) du champ magnétique, selon les tronçons de la bande magnétorésistive.

**11.** Capteur à effet magnétorésistif selon la revendication 10, caractérisé en ce que la bande magnétorésistive est repliée selon un motif en créneau et en ce que le guide de flux (8) comporte des languettes (12) pour diriger les lignes (F) de champ selon les tronçons (7b) qui sont eux-mêmes perpendiculaires à la longueur (L) du composant.

**12.** Capteur à effet magnétorésistif selon la revendication 10, caractérisé en ce que la bande magnétorésistive est repliée selon un motif en serpentin présentant une succession de parties courbées (20) et de tronçons perpendiculaires (22) à la longueur du composant, et en ce que le guide de flux comporte des languettes (12) pour diriger les lignes de champ selon lesdits tronçons perpendiculaire (22).

**13.** Capteur à effet magnétorésistif selon la revendication 10, caractérisé en ce que la bande magnétorésistive est repliée selon un motif en dents de scie présentant une succession de tronçons (24, 26) et en ce que le guide de flux comporte des languettes (12) pour diriger les lignes de champ selon lesdits tronçons (24, 26).

**Patentansprüche**

**1.** Magnetoresistive Anordnung mit einem magnetoresistiven Streifen (2) des mehrschichtigen Typs, gebogen entsprechend sich wiederholenden geometrischen Mustern (7a, 7b, 22, 24, 26), um wenigstens eine Serie von im wesentlichen parallelen Abschnitten (7a, 7b, 22, 24, 26) mit wenigstens einer Richtung aufzuweisen, wobei das magnetoresistive Band (2) gebildet wird durch einen Stapel unabhängiger Schichten aus magnetischem metallischem Material, getrennt durch Schichten (15) aus unmagnetischem metallischem Material.

**2.** Magnetoresitive Anordnung nach Anspruch 1, dadurch gekennzeichnet, daß das Muster ausgewählt wird unter folgenden Mustern: schlangenförmiges Muster (20, 22), sägezahnförmiges Muster (24, 26), rechteckförmiges Muster (7a, 7b).

**3.** Magnetoresitive Anordnung nach einem der Ansprüche 1 oder 2, dadurch gekennzeichnet, daß der Streifen (2) nach einem rechteckkförmigen Muster gebogen ist, das zwei Serien (7a, 7b) von Abschnitten aufweist, jeweils ausgerichtet nach zwei im wesentlichen zueinander senkrechten Richtungen.

**4.** Magnetoresitive Anordnung nach einem der vorangehenden Ansprüche, dadurch gekennzeichnet, daß das magnetische Material eine Legierung aus Eisen und aus Nickel ist.

**5.** Magnetoresitive Anordnung nach einem der vorangehenden Ansprüche, daß das unmagnetische Material zwischen Kupfer und Silber gewählt wird.

**6.** Magnetoresitive Anordnung nach einem der vorangehenden Ansprüche, dadurch gekennzeichnet, daß das Muster des magnetoresistiven Streifens (2) mittels eines Photolithographieverfahrens hergestellt wird.

**7.** Fühler mit magnetoresistivem Effekt, bestimmt zur Messung von Magnetfeldern, eine magnetoresistive Anordnung (1) umfassend, getragen durch ein nichtleitendes Substrat (12), und Kontaktstellen (5, 6), verbunden mit der Anordnung (1) durch Stromzuführungen (3, 4), bei dem die magnetoresistive Anordnung (1) konform ist mit einem der vorangehenden Ansprüche.

**8.** Magnetoresitiver Fühler nach Anspruch 7, dadurch gekennzeichnet, daß die Breite (t) der Abschnitte (7b) von einer der Serien kleiner ist als die Länge (v) dieser Abschnitte.

**9.** Magnetoresitiver Fühler nach Anspruch 8, dadurch gekennzeichnet, daß die genannte Länge v der Abschnitte (7b) $\geq 10$µm ist und die Breite t dieser Abschnitte so ist, daß 0,2µm$\leq$t$\leq$5µm.

**10.** Magnetoresitiver Fühler nach einem der Ansprüche 7 bis 9, dadurch gekennzeichnet, daß er außerdem einen Flußleiter (8) umfaßt, um die Linien (F) des Magnetfeldes entsprechend den Abschnitten des magnetoresistiven Streifens auszurichten.

**11.** Magnetoresitiver Fühler nach Anspruch 10, dadurch gekennzeichnet, daß der magnetoresistive Streifen nach einem rechteckförmigen Muster gebogen ist, und dadurch, daß der Flußleiter (8) Zungen (12) zum Ausrichten der Feldlinien (F) entsprechend den Abschnitten (7b) umfaßt, die ihrerseits selbst senkrecht zu der Länge (L) der Anordnung sind.

**12.** Magnetoresitiver Fühler nach Anspruch 10, dadurch gekennzeichnet, daß der magnetoresistive Streifen nach einem schlangenförmigen Muster gebogen ist, das eine Folge von gekrümmten Teilen (20) aufweist und zur Länge der Anordnung senkrechte Abschnitte (22), und dadurch, das der Flußleiter Zungen (12) umfaßt, um die Feldlinien entsprechend den genannten senkrechten Abschnitten (22) auszurichten.

**13.** Magnetoresitiver Fühler nach Anspruch 10, dadurch gekennzeichnet, daß der magnetoresitive Streifen nach einem sägezahnförmigen Muster gebogen ist, das eine Folge von Abschnitten (24, 26) aufweist, und dadurch, daß der Flußleiter Zungen (12) umfaßt, um die Feldlinien entsprechend den genannten Abschnitten (24, 26) auszurichten.

**Claims**

**1.** Magnetoresistive component having a multilayer-type magnetoresistive strip (2) bent in accordance with a repeated geometrical pattern (7a, 7b, 22, 24, 26), so as to have at least one series of sections (7a, 7b, 22, 24, 26) substantially parallel to at least one direction, the magnetoresistive strip (2) being formed by a stack (13) of independent, magnetic metallic material layers (14) separated by non-magnetic metallic material layers (15).

**2.** Magnetoresistive component according to claim 1, characterized in that the pattern is chosen from among one of the following patterns: serpentine (20, 22), sawtooth (24, 26) and crenellated (7a, 7b).

**3.** Magnetoresistive component according to either of the claims 1 and 2, characterized in that the strip (2) is bent in accordance with a crenellated pattern having two series (7a, 7b) of sections respectively aligned in accordance with two directions (x, y) substantially perpendicular to one another.

**4.** Magnetoresistive component according to any one of the preceding claims, characterized in that the magnetic material is an alloy of iron and nickel.

**5.** Magnetoresistive component according to any one of the preceding claims, characterized in that the non-magnetic material is chosen from among copper and silver.

**6.** Magnetoresistive component according to any one of the preceding claims, characterized in that the pattern of the magnetoresistive strip (2) is obtainable by a photolithography process.

**7.** Magnetoresistive transducer for measuring magnetic fields, having a magnetoresistive component (1) supported by a non-conductive substrate (12) and power points (5, 6) connected to the component (1) by leads (3, 4), wherein the magnetoresistive component (1) is in accordance with any one of the preceding claims.

**8.** Magnetoresistive transducer according to claim 7, characterized in that the width (t) of the sections (7b) of one of the series is smaller than the length (v) of said sections.

**9.** Magnetoresistive transducer according to claim 8, characterized in that the length (v) of the sections (7b) is $\geq$ 10 pm and the width t of said sections is such that 0.2 $\mu$m $\leq$ t $\leq$ 5 $\mu$m.

**10.** Magnetoresistive transducer according to any one of the claims 7 to 9, characterized in that it also has a flux guide (8) for orienting the lines (F) of the magnetic field along the sections of the magnetoresistive strip.

**11.** Magnetoresistive transducer according to claim 10, characterized in that the magnetoresistive strip is bent in accordance with a crenellated pattern and in that the flux guide (8) has tongues (12) for directing the field lines (F) along the sections (7b), which are themselves perpendicular to the component length (L).

**12.** Magnetoresistive transducer according to claim 10, characterized in that the magnetoresistive strip is bent in accordance with serpentine pattern having a succession of curved portions (20) and sections (22) perpendicular to the component length and in that the flux guide has tongues (12) for directing the field lines along said perpendicular sections (22).

**13.** Magnetoresistive transducer according to claim 10, characterized in that the magnetoresistive strip is bent according to a sawtooth pattern having a succession of sections (24, 26) and in that the flux guide has tongues (12) for directing the field lines along said sections (24, 26).

FIG. 1

FIG. 4

FIG. 2

FIG. 3

FIG. 5

FIG. 6E

FIG. 6F

FIG. 6 A

FIG. 6 B

FIG. 6 C

FIG. 6 D

FIG. 7

FIG. 8

FIG. 9

FIG. 10